# EUROPÄISCHE PATENTSCHRIFT

(11) **EP 3 818 382 B1**
(45) Veröffentlichungstag und Bekanntmachung des Hinweises auf die Patenterteilung: **19.10.2022**
(21) Anmeldenummer: 18768812.2
(22) Anmeldetag: 04.09.2018
(51) Int. Cl.: G01R 1/20

(54) **STROMMESSWIDERSTAND UND ZUGEHÖRIGES HERSTELLUNGSVERFAHREN**
CURRENT MEASURING RESISTOR AND ASSOCIATED PRODUCTION METHOD
RÉSISTANCE DE MESURE DU COURANT ET PROCÉDÉ DE FABRICATION ASSOCIÉ

(43) Veröffentlichungstag der Anmeldung: 12.05.2021
(73) Patentinhaber: Isabellenhütte Heusler GmbH & Co. KG, 35683 Dillenburg (DE)
(72) Erfinder: SEEL, Benjamin, 35689 Dillenburg-Eibach (DE); MARIEN, Jan, 35745 Herborn (DE); BERNHARDT, Florian, 35685 Dillenburg, Manderbach (DE); HERB, Siegfried, 57074 Siegen (DE); POLLMANN, Michael, 35689 Dillenburg (DE); WASSMANN, Alexander, 57072 Siegen (DE)
(74) Vertreter: v. Bezold & Partner Patentanwälte - PartG mbB
(86) Internationale Anmeldenummer: PCT/EP2018/073686
(87) Internationale Veröffentlichungsnummer: WO 2020/048584

(56) Entgegenhaltungen:
- DE-A1-102012 211 701
- DE-A1-102013 005 939
- JP-A- 2009 216 620

## Beschreibung

Die Erfindung betrifft einen Strommesswiderstand zur Messung eines elektrischen Stroms, insbesondere im kA-Bereich in einem Hochspannungsnetz. Weiterhin betrifft die Erfindung ein entsprechendes Herstellungsverfahren für einen solchen Stromnetzwiderstand.

Aus dem Stand der Technik (z.B. EP 0 605 800 A1) sind niederohmige Strommesswiderstände bekannt, die eine Strommessung gemäß der bekannten Vierleitertechnik ermöglichen. Dabei wird der zu messende Strom durch den niederohmigen Strommesswiderstand geleitet und der Spannungsabfall über dem Strommesswiderstand gemessen. Der Spannungsabfall über dem Strommesswiderstand ist dabei entsprechend dem Ohmschen Gesetz ein Maß für den elektrischen Strom, der durch den Strommesswiderstand fließt. Die bekannten Strommesswiderstände gemäß EP 0 605 800 A1 werden üblicherweise aus einem Verbundmaterialband abgetrennt und haben deshalb in einer Schnittebene rechtwinklig zur Stromflussrichtung einen rechteckigen Querschnitt. Diese bekannten Strommesswiderstände eignen sich jedoch nicht zur Strommessung von Wechselströmen im kA-Bereich in einem Hochspannungsnetz. Die rechteckige Form des Widerstands führt nämlich insbesondere bei Wechselströmen zu stark ort- und frequenzabhängigen Verteilungen der Amplituden und Phasenlagen.

Ferner umfasst der allgemeine technische Hintergrund der Erfindung die Veröffentlichungen DE 10 2013 005 939 A1 und JP 2009/216620 A1.

Schließlich offenbart DE 10 2012 211 701 A1 einen Strommessswiderstand gemäß dem Oberbegriff von Anspruch 1.

Der Erfindung liegt deshalb die Aufgabe zugrunde, einen entsprechend verbesserten Strommesswiderstand und ein Herstellungsverfahren dafür anzugeben.

Diese Aufgabe wird durch einen erfindungsgemäßen Strommesswiderstand und ein entsprechendes Herstellungsverfahren gemäß den unabhängigen Ansprüchen gelöst.

Der erfindungsgemäße Strommesswiderstand weist zunächst in Übereinstimmung mit den eingangs beschriebenen bekannten Strommesswiderständen zwei Anschlussteile aus einem Leitermaterial (z.B. Kupfer) auf, um den zu messenden elektrischen Strom in den Strommesswiderstand einzuleiten bzw. aus dem Strommesswiderstand auszuleiten.

Darüber hinaus weist der erfindungsgemäße Strommesswiderstand in Übereinstimmung mit dem Stand der Technik ein Widerstandselement auf, das aus einem niederohmigen Widerstandsmaterial (z.B. Noventin^{®}, d.h. CuMnNi₂₅₋₁₀) besteht, wobei das Widerstandselement in Stromflussrichtung zwischen den beiden Anschlussteilen angeordnet ist und mit den beiden Anschlussteilen zusammengefügt ist, so dass der zu messende elektrische Strom in Betrieb durch das Widerstandselement fließt und einen Spannungsabfall über dem Widerstandselement erzeugt, der ein Maß für den zu messenden elektrischen Strom bildet.

Der erfindungsgemäße Strommesswiderstand unterscheidet sich nun von dem eingangs beschriebenen bekannten Strommesswiderstand dadurch, dass die Leiterplatte eine flexible Leiterplatte ist, die entsprechend der Außenkontur des Strommesswiderstands in Umfangsrichtung gewölbt oder geknickt ist. Dies ermöglicht vorteilhaft eine konstruktive Auslegung des Strommesswiderstands zur Messung hoher Wechselströme im kA-Bereich in einem Hochspannungsnetz.

Der im Rahmen der Erfindung verwendete Begriff eines runden Querschnitts ist nicht beschränkt auf einen im mathematisch-geometrischen Sinne exakt kreisrunden Querschnitt. Vielmehr kann der Querschnitt auch durch ein Polygon nachgebildet sein, das eine Vielzahl von Ecken aufweist, wie beispielsweise 16 Ecken. In jedem Fall aber unterscheidet sich der erfindungsgemäße Strommesswiderstand von den eingangs beschriebenen bekannten Strommesswiderständen mit einem viereckigen und rechteckigen Querschnitt. In einem bevorzugten Ausführungsbeispiel ist der Querschnitt der Anschlussteile und des Widerstandselements im Wesentlichen kreisrund und weist lediglich Abplattungen auf, die den Herstellungsprozess erleichtern bzw. die Montage einer Leitplatte ermöglichen, wie noch detailliert beschrieben wird.

In dem bevorzugten Ausführungsbeispiel der Erfindung weist das runde Widerstandselement einen größeren Außendurchmesser auf als die beiden runden Anschlussteile, wobei das Widerstandselement bezüglich der Stromflussrichtung mittig zwischen den beiden Anschlussteilen angeordnet ist.

Hierbei weist der Strommesswiderstand zwischen den beiden äußeren Anschlussteilen mit dem kleineren Außendurchmesser und dem mittigen Widerstandselement mit dem größeren Außendurchmesser eine Übergangskontur auf, die glatt und knickfrei sein kann, um eine homogene Stromverteilung zu erreichen. Beispielsweise kann die Übergangskontur auch einen konkaven Abschnitt aufweisen.

Weiterhin ist zu der Übergangskontur zu erwähnen, dass sich die Übergangskontur vorzugsweise ausschließlich in den Anschlussteilen befindet, während der Außendurchmesser des Widerstandselements entlang seiner Länge im Wesentlichen konstant ist. Es besteht jedoch alternativ auch die Möglichkeit, dass sich die Übergangskontur auch bis in das Widerstandselement erstreckt oder ausschließlich im Widerstandselement angeordnet ist.

Es wurde bereits vorstehend erwähnt, dass die Anschlussteile mit dem Widerstandselement zusammengefügt sind, wie es grundsätzlich auch bei den eingangs beschriebenen bekannten Strommesswiderständen der Fall ist.

In einer Variante der Erfindung erfolgt diese Verbindung zwischen dem Widerstandselement einerseits und dem Anschlussteil andererseits durch Elektronenstrahlschweißen, wie es auch aus der bereits eingangs erwähnten Patentanmeldung EP 0 605 800 A1 bekannt ist. Allerdings muss der Elektronenstrahl bei der Herstellung einer solchen Elektronenstrahlschweißverbindung von der äußeren Mantelfläche ausgehend bis zum Mittelpunkt des Strommesswiderstands reichen. Dies ist jedoch aufgrund des relativ großen Außendurchmessers des erfindungsgemäßen Strommesswiderstands relativ schwierig, weshalb eine Elektronenstrahlschweißverbindung nicht optimal ist.

In einer anderen, bevorzugten Variante der Erfindung erfolgt die Verbindung zwischen dem Widerstandselement einerseits und den Anschlussteilen andererseits deshalb durch Hartlöten (z.B. Vakuumhartlöten), was vorzugsweise in einem Ofen geschieht, der mit entsprechender Heizleistung in der Lage ist, die Werkstücke (Widerstandselement und Anschlussteile) homogen zu erwärmen und einem bestimmten zeitlichen Temperaturprofil auszusetzen. Hierbei tragen auch die Abkühlgradienten und die Abkühlzeiten zur Qualität der Hartlötverbindung bei. Für die Hartlötung ist in der Regel auch ein bestimmter Druck auf die Fügeverbindung notwendig. Die zu verbindenden Werkstücke (Widerstandselement und Anschlussteile) weisen jedoch bei dem erfindungsgemäßen Strommesswiderstand ein relativ hohes Eigengewicht auf, so dass in der Regel keine zusätzlicher

Druck von außen auf die Werkstücke notwendig ist.

Vorzugsweise erfolgt das Hartlöten im Rahmen eines Vakuumhartlötprozesses, wobei derartige Prozesse an sich aus dem Stand der Technik bekannt sind und deshalb nicht mehr beschrieben werden müssen.

Weiterhin ist zu erwähnen, dass das Widerstandsmaterial des Widerstandselements Mangan enthalten kann, was eine gute Lötverbindung erschwert. Vorzugsweise werden die Fügeflächen des Widerstandselements deshalb vor dem Zusammenfügen (Hartlöten) mit einer schichtförmigen Oberflächenveredelung versehen, die beispielsweise Nickel, Nickel-Phosphor (NiP), Gold oder Silber als Inhaltsstoffe aufweisen kann. Hierbei sind die Zusammensetzung der Legierung bzw. die Zusätze zum Nickel entscheidend für die Lötverbindung. Je edler die Nickel-Legierung ist, desto schneller bildet diese wieder eine Passivierung, was wiederum schlechter zu löten ist. Diese Oberflächenveredlung ermöglicht trotz eines manganhaltigen Widerstandsmaterials eine gute Lötverbindung.

Bei dem erfindungsgemäßen Strommesswiderstand ist auf der Mantelfläche des Strommesswiderstands eine Leiterplatte montiert, um den Spannungsabfall über dem Widerstandselement zu messen. Diese Leiterplatte ist eine flexible Leiterplatte (Flex-Leiterkarte), die entsprechend der Außenkontur des Strommesswiderstands in Umfangsrichtung gewölbt oder geknickt ist.

Die Leiterplatte ist vorzugsweise durch eine Schweißverbindung mit dem Strommesswiderstand verbunden, beispielsweise durch eine Ultraschallschweißverbindung oder eine Laserschweißverbindung. Die Schweißverbindung kann beispielsweise nur im Bereich der Anschlussteile liegen, um dort auch Spannungsabgriffe auf der Innenseite der Leiterplatte mit den Anschlussteilen elektrisch und mechanisch zu verbinden. Es besteht jedoch alternativ auch die Möglichkeit, dass die Schweißverbindung zwischen der Leiterplatte und dem Strommesswiderstand nur im Bereich des Widerstandselements liegt, um die Spannungsabgriffe innerhalb des Widerstandselements anzuordnen. Ferner besteht auch die Möglichkeit, dass sich die Schweißverbindung sowohl über die Anschlussteile als auch über das Widerstandselement erstreckt. Alternativ besteht auch die Möglichkeit, die Leiterplatte durch eine Lötverbindung mit dem Strommesswiderstand zu verbinden.

Zu der Leiterplatte ist auch zu erwähnen, dass die Leiterplatte vorzugsweise mindestens zweilagig ausgeführt ist, um von beiden Seiten zugänglich zu sein.

Ferner kann die Leiterplatte zur Messung der Temperatur des Widerstandselements auch einen Temperatursensor tragen, insbesondere einen NTC-Widerstand (NTC: negative temperature coefficient) oder einen PTC-Widerstand (PTC: positive temperature coefficient). Alternativ möglich sind als Temperatursensor auch Chip-Temperatursensoren (Pt100, Pt1000, Ptx, 1-Wire, etc.)

In dem bevorzugten Ausführungsbeispiel der Erfindung ist nicht nur ein einziges Paar von Spannungsabgriffen vorgesehen, um den Spannungsabfall über dem Widerstandselement zu messen. Vielmehr sind vorzugsweise mehrere Paare von Spannungsabgriffen vorgesehen, die an unterschiedlichen Stellen an dem Strommesswiderstand angeordnet sind und jeweils einen entsprechenden Spannungsmesswert liefern. Die Paare von Spannungsabgriffen sind vorzugsweise über den Umfang des Strommesswiderstand verteilt angeordnet und zwar vorzugsweise äquidistant. Beispielsweise kann die Anzahl der Paare von Spannungsabgriffen größer sein als 2, 4, 8, 12 oder 14, wobei in dem bevorzugten Ausführungsbeispiel der Erfindung genau 16 Paare von Spannungsabgriffen vorgesehen sind.

Beispielsweise können die Spannungsabgriffe direkt an der Leiterplatte angebracht sein und direkt auf der Mantelfläche der Anschlussteile aufliegen. Die Spannungsabgriffe können dann auf der dem Strommesswiderstand zugewandten Seite der Leiterplatte angebracht sein und kontaktieren die Anschlussteile nach dem Aufschweißen der Leiterplatte. Vorzugsweise sind die Spannungsabgriffe jedoch durchkontaktiert auf beiden Seiten der Leiterplatte zugänglich.

Es wurde bereits vorstehend kurz erwähnt, dass die einzelnen Paare von Spannungsabgriffen jeweils einen Spannungsmesswert liefern. Aus den einzelnen Spannungsmessungswerten kann dann beispielsweise ein Mittelwert gebildet werden, der dann das Maß für den durch den Strommesswiderstand fließenden elektrischen Strom bildet. Vorzugsweise sind jedoch Gewichtungswiderstände vorgesehen, um die einzelnen Spannungsmesswerte zu gewichten, wobei dann aus den gewichteten Spannungsmesswerten ein resultierender Messwert ermittelt wird. Diese Gewichtungswiderstände können ebenfalls auf der Leiterplatte angeordnet sein.

Die Paare von Spannungsabgriffen sind vorzugsweise mit einer Messschaltung verbunden, die den Spannungsabfall über dem Widerstandselement ermittelt, wobei die Messschaltung den Spannungsabfall über dem Widerstandselement vorzugsweise aus den gewichteten Spannungsmesswerten berechnet. Die Messschaltung ist dabei vorzugsweise nicht auf der Leiterplatte selbst angeordnet, sondern auf mindestens einer separaten Messkarte, die durch eine Leitung mit der Leiterplatte verbunden ist.

Die Messschaltung kann auch mit einer Datenschnittstelle verbunden sein, um Messwerte des Spannungsabfalls an eine externe Auswertungseinheit zu übertragen. Vorzugsweise ist diese Datenschnittstelle eine elektro-optische Datenschnittstelle, welche die Messwerte über einen Lichtwellenleiter an die externe Auswertungseinheit überträgt.

Zur Schaffung von Redundanz bei der Messung sind vorzugsweise mindestens zwei Messkarten vorgesehen, die jeweils eine Messschaltung aufweisen, wobei die beiden Messschaltungen eingangsseitig mit der Leiterplatte verbunden sind und die Spannungsmesswerte der einzelnen Paare von Spannungsabgriffen aufnehmen.

Die einzelnen Messschaltungen können jeweils mindestens zwei oder mindestens drei Messpfade aufweisen, wobei die einzelnen Messpfade jeweils die Messwerte für den Spannungsabfall über dem Widerstandselement von der Leiterplatte aufnehmen. Bei drei Messpfaden können die beiden ersten Messpfade beispielsweise die gleiche Signalverstärkung aufweisen, während der dritte Messpfad eine geringere Signalverstärkung aufweist.

Es wurde bereits vorstehend kurz erwähnt, dass die Außenkontur des Strommesswiderstands nicht exakt rund sein muss, sondern Abplattungen in der Mantelfläche aufweisen kann, um die Leiterplatte planparallel auf der Abplattung zu montieren.

In dem bevorzugten Ausführungsbeispiel der Erfindung sind über den Umfang des Strommesswiderstands verteilt mehrere Abplattungen in der Mantelfläche des Strommesswiderstands angeordnet und zwar vorzugsweise mehr als 2, 4, 6, 8, 10, 12 oder 14 Abplattungen. In dem bevorzugten Ausführungsbeispiel ist der Strommesswiderstand im Querschnitt ein Polygon mit 16 Abplattungen. Hierbei ist die Leiterplatte entsprechend der Anzahl der Abplattungen in dem Strommesswiderstand mehrfach geknickt und enthält zwischen den Knickstellen jeweils ebene Leiterplattenabschnitte, die jeweils planparallel auf einer der Abplattungen montiert sind. Bei dem Ausführungsbeispiel des erfindungsgemäßen Strommesswiderstands mit 16 Abplattungen in der Mantelfläche des Strommesswiderstands weist die Leiterplatte entsprechend 16 ebene Leiterplattenabschnitte auf, die dann jeweils planparallel auf einer der Abplattungen aufliegen.

Hierbei ist zu erwähnen, dass sich die Abplattungen in axialer Richtung vorzugsweise aus dem Bereich des Widerstandselements bis in die Bereiche der angrenzenden Anschlussteile erstrecken.

Die vorstehend beschriebene Messschaltung und weitere elektronische Komponenten des Strommesswiderstands benötigen im Betrieb eine Stromversorgung, die bei dem erfindungsgemäßen Strommesswiderstand grundsätzlich in herkömmlicher Weise erfolgen kann. In dem bevorzugten Ausführungsbeispiel der Erfindung weist der Strommesswiderstand jedoch zur Energiegewinnung aus dem Magnetfeld des Strommesswiderstands durch Energy-Harvesting mindestens eine Spule auf. Im Betrieb erzeugt der durch den Strommesswiderstand fließende elektrische Strom ein Magnetfeld, welches die Energy-Harvesting-Spule durchsetzt und dadurch eine Energiegewinnung ermöglicht. Diese Spule kann dann die zum Betrieb der Messschaltung benötigte elektrische Energie liefern und zwar allein oder mit einer zusätzlichen Energieversorgung. Vorzugsweise weist die Spule mindestens 20, 50, 100 oder 140 Windungen auf, wobei in dem bevorzugten Ausführungsbeispiel der Erfindung genau 150 Windungen vorgesehen sind. Darüber hinaus enthält die Spule vorzugsweise einen Magnetkern, der die Anschlussteile ringförmig umgibt und mit der Spule bewickelt ist. In dem bevorzugen Ausführungsbeispiel der Erfindung sind mehrere Spulen vorgesehen, die jeweils eines der beiden Anschlussteile ringförmig umgeben.

Darüber hinaus kann auch ein Stromspeicher in dem Strommesswiderstand integriert sein, insbesondere mindestens ein so genannter Power-Cap mit einer Kapazität von mindestens 10 mF, 50 mF, 100 mF, 500 mF oder mindestens 1.000 mF.

Zur alleinigen oder unterstützenden Stromversorgung kann auch eine Photozelle in dem Strommesswiderstand integriert sein.

Bei dem Leitermaterial handelt es sich vorzugsweise um Kupfer oder eine Kupferlegierung, jedoch sind im Rahmen der Erfindung grundsätzlich auch andere Leitermaterialien möglich. Allerdings sollte das Leitermaterial der Anschlussteile einen geringeren spezifischen elektrischen Widerstand haben als das Widerstandsmaterial des Widerstandselements.

Beispielsweise kann es sich bei dem Widerstandsmaterial des Widerstandselements um eine Kupfer-Mangan-Nickel-Legierung handeln, insbesondere mit 25 Gew% Mangan, 10 Gew% Nickel und dem Rest Kupfer oder mit 12 Gew% Mangan, 2 Gew% Nickel und dem Rest Kupfer.

Das Widerstandsmaterial des Widerstandselements weist vorzugsweise einen spezifischen elektrischen Widerstand auf, der kleiner ist als 1.000 µΩcm, 500 µΩcm, 250 µΩcm, 100 µΩcm oder 50 µΩcm.

Das Leitermaterial der Anschlussteile weist dagegen vorzugsweise einen spezifischen elektrischen Widerstand auf, der kleiner ist als 20 µΩcm, 10 µΩcm, 5 µΩcm oder 2 µΩcm.

Ferner ist zu erwähnen, dass das Widerstandselement, das erste Anschlussteil und/oder das zweite Anschlussteil vorzugsweise ohne Hohlräume massiv ausgeführt sind. Zum einen ist dies vorteilhaft, weil Hohlräume in dem Strommesswiderstand das Eindringen von Wasser ermöglichen könnten. Zum anderen ist die massive Ausführung des Strommesswiderstands aber auch vorteilhaft, weil der erfindungsgemäße Strommesswiderstand für eine ausreichende Kurzschlussfestigkeit eine große Masse haben muss, damit er die bei einem Kurzschluss entstehende thermische Verlustleistung puffern kann, ohne dass sich der Widerstandswert wesentlich ändert.

Ferner ist zu erwähnen, dass die Anschlussteile in ihrer Mantelfläche jeweils eine axial verlaufende Längsnut aufweisen können, die von der Stirnfläche der Anschlussteile ausgeht. Diese Längsnuten ermöglichen vorteilhaft eine Verdrehsicherung.

Weiterhin können die beiden Anschlussteile jeweils in ihren Stirnflächen eine axial verlaufende Sackbohrung aufweisen, insbesondere mit einem Innengewinde, wobei die Sackbohrung vorzugsweise zentrisch und koaxial angeordnet ist. Diese Sackbohrung ermöglicht beispielsweise den Anschluss von Kabeln.

Darüber hinaus können die Anschlussteile in ihrer Mantelfläche jeweils mindestens eine radial verlaufende Sackbohrung zur Gehäusemontage aufweisen, wobei sich diese Sackbohrung beispielsweise in der Übergangskontur des Strommesswiderstands befinden kann.

Es wurde bereits vorstehend erwähnt, dass der Strommesswiderstand im Bereich des Widerstandselements im Querschnitt ein Polygon bildet, um die mehrfach eingeknickte Leiterplatte montieren zu können. In den Anschlussteilen befinden sind deshalb vorzugsweise entsprechende Ringnuten mit einem ebenfalls polygonalen Querschnitt in der gleichen Ausrichtung in Umfangsrichtung. Diese Ringnuten mit dem polygonalen Querschnitt dienen dann als Fertigungshilfen bei der automatisierten Montage der Leiterplatte.

Der erfindungsgemäße Strommesswiderstand unterscheidet sich von den eingangs beschriebenen bekannten Strommesswiderständen auch durch die wesentlich größeren Abmessungen, die an eine Strommessung im kA-Bereich angepasst sind. Der Außendurchmesser des runden Widerstandselements kann deshalb mindestens 6 cm, 7 cm, 8 cm oder 9 cm betragen, wobei der Außendurchmesser des runden Widerstandselements bei dem bevorzugten Ausführungsbeispiel der Erfindung im Wesentlichen 10 cm beträgt. Der Außendurchmesser der runden Anschlussteile beträgt dagegen vorzugsweise mindestens 2 cm, 3 cm, 4 cm oder 5 cm und ist somit wesentlich geringer als der Außendurchmesser des runden Widerstandselements.

In axialer Richtung weist der erfindungsgemäße Strommesswiderstand dagegen vorzugsweise eine relativ große Länge von mindestens 10 cm, 20 cm, 30 cm, 40 cm, 50 cm oder 60 cm auf, wobei die Länge des Strommesswiderstands in dem bevorzugten Ausführungsbeispiel im Wesentlichen 64 cm beträgt.

Das einzelne Widerstandselement weist dagegen in Stromflussrichtung vorzugsweise eine axiale Länge von mindestens 1 cm, 2 cm, 3 cm, 4 cm, 5 cm oder 6 cm auf, wobei die Länge des Widerstandselements bei dem bevorzugten Ausführungsbeispiel im Wesentlichen 7 cm beträgt.

Die einzelnen Anschlussteile weisen dabei in Stromflussrichtung vorzugsweise eine axiale Länge von mindestens 10 cm, 20 cm, 25 cm oder 30 cm auf, wobei die axiale Länge der einzelnen Anschlussteile bei dem bevorzugten Ausführungsbeispiel der Erfindung im Wesentlichen 31 cm beträgt.

Auch die Masse der Anschlussteile und des Widerstandselements ist bei dem erfindungsgemäßen Strommesswiderstand vorzugsweise wesentlich größer als bei den eingangs beschriebenen bekannten Strommesswiderständen, um eine ausreichende Stromtragfähigkeit und Kurzschlussfestigkeit zu ermöglichen. So haben die Anschlussteile jeweils vorzugsweise eine Masse von mindestens 1 kg, 2 kg, 5 kg, 10 kg, 15 kg oder 20 kg und in dem bevorzugten Ausführungsbeispiel im Wesentlichen 22 kg. Das Widerstandselement hat dagegen vorzugsweise eine Masse von mindestens 0,5 kg, 1 kg, 1,5 kg oder 2 kg, wobei die Masse in dem bevorzugten Ausführungsbeispiel im Wesentlichen 2 kg beträgt.

Der erfindungsgemäße Strommesswiderstand unterscheidet sich von den bekannten Strommesswiderständen auch durch eine sehr hohe Dauerstrombelastbarkeit, die bei Wechselstrom bei mindestens 1 kA, 5 kA, 10 kA, 15 kA, 50 kA, 75 kA, 95 kA oder sogar mindestens 100 kA liegt.

Darüber hinaus ist der Strommesswiderstand auch für ein relativ hohes Spannungsniveau ausgelegt und eignet sich bei Wechselstrom für Spannungen von mindestens 1 kV, 5 kV, 10 kV, 50 kV, 110 kV, 220 kV oder mindestens 380 kV.

Weiterhin ist zu erwähnen, dass die Erfindung nicht nur Schutz beansprucht für den erfindungsgemäßen Strommesswiderstand als einzelnes Bauteil. Vielmehr beansprucht die Erfindung auch Schutz für ein entsprechendes Herstellungsverfahren. Die einzelnen Verfahrensschritte des erfindungsgemäßen Herstellungsverfahrens ergeben sich bereits aus der vorstehenden Beschreibung, so dass auf eine separate Beschreibung des erfindungsgemäßen Herstellungsverfahrens verzichtet werden kann.

Andere vorteilhafte Weiterbildungen der Erfindung sind in den Unteransprüchen gekennzeichnet oder werden nachstehen zusammen mit der Beschreibung des bevorzugten Ausführungsbeispiels der Erfindung anhand der Figuren näher erläutert. Es zeigen:

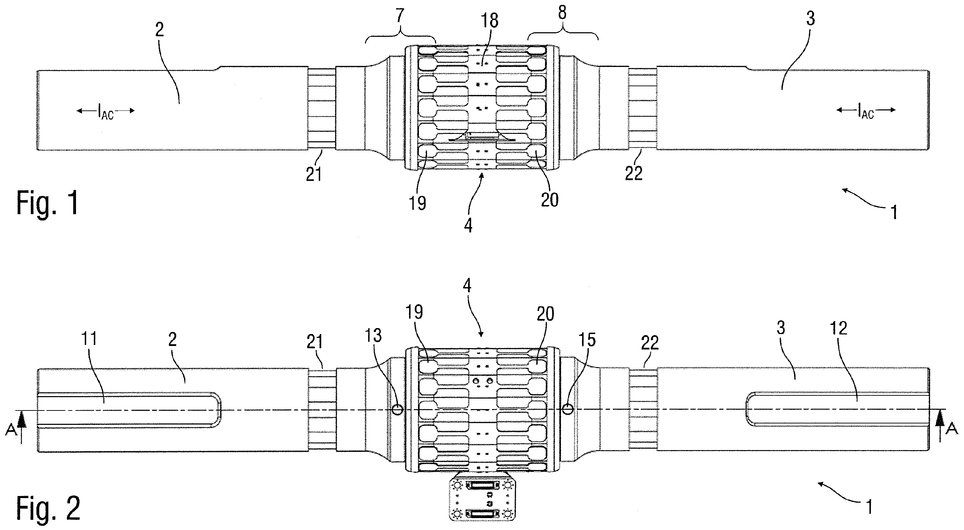

- Figur 1: eine Seitenansicht eines erfindungsgemäßen Strommesswiderstands,
- Figur 2: eine andere Seitenansicht des erfindungsgemäßen Strommesswiderstands aus Figur 1,

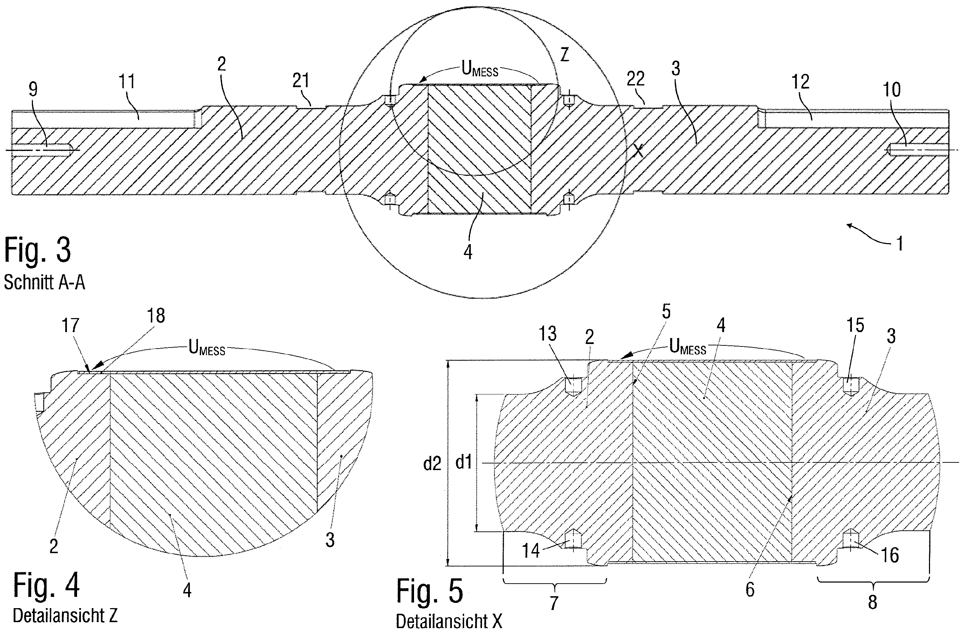

- Figur 3: eine Schnittansicht gemäß der Schnittlinie A-A in Figur 2,
- Figur 4: eine Detailansicht des Detailbereichs Z in Figur 3,
- Figur 5: eine Detailansicht des Detailbereichs X in Figur 3,
- Figur 6: eine perspektivische Explosionsdarstellung des erfindungsgemäßen Strommesswiderstands,
- Figur 7: das erfindungsgemäße Herstellungsverfahren in Form eines Flussdiagramms.

Die Zeichnungen zeigen ein Ausführungsbeispiel eines erfindungsgemäßen Strommesswiderstands 1, der in Hochspannungsnetzen von beispielsweise 220 kV Wechselstrom zur Strommessung im kA-Bereich eingesetzt werden kann.

Der Strommesswiderstand 1 weist zunächst zwei Anschlussteile 2, 3 aus Kupfer auf, die dazu dienen, einen zu messenden elektrischen Strom I_{AC} in den Strommesswiderstand 1 einzuleiten bzw. aus dem Strommesswiderstand 1 auszuleiten.

In Stromflussrichtung zwischen den beiden Anschlussteilen 2, 3 befindet sich ein Widerstandselement 4 aus einem Widerstandsmaterial (z.B. Noventin^{®}, d.h. CuMnNi₂₅₋₁₀).

Das Widerstandselement 4 ist an seinen beiden Stirnflächen durch eine Hartlötverbindung mit den beiden Anschlussteilen 2, 3 verbunden. Zur Ermöglichung dieses Hartlötprozesses trotz des ansonsten störenden Mangan-Anteils des Widerstandsmaterials weist das Widerstandselement 4 an beiden Fügeflächen eine schichtförmige Oberflächenveredelung 5, 6 aus Nickel-Phosphor (NiP) auf. Die Oberflächenveredelungen 5, 6 werden vor dem Herstellen der Lötverbindung aufgebracht, um den anschließenden Lötvorgang trotz des Mangan-Anteils des Widerstandselements 4 zu ermöglichen bzw. zu erleichtern.

Die Anschlussteile 2, 3 und das Widerstandselement 4 weisen grundsätzlich einen im Wesentlichen kreisrunden Querschnitt auf, und zwar mit einem kleineren Durchmesser d1 im Bereich der Anschlussteile 2, 3 und einem größeren Außendurchmesser d2 im Bereich des Widerstandselements 4. Für eine Durchmesseranpassung zwischen den beiden Außendurchmessern d1, d2 weist das Anschlussteil 2 eine Übergangskontur 7 auf, während das andere Anschlussteil 3 eine entsprechende Übergangskontur 8 aufweist. Die beiden Übergangskonturen 7, 8 bilden den Übergang von dem kleinen Außendurchmesser d1 der Anschlussteile 2, 3 auf den größeren Außendurchmesser d2 des Widerstandselements 4. Hierbei ist zu erwähnen, dass die beiden Übergangskonturen 7, 8 jeweils einen konkaven Abschnitt aufweisen, um eine möglichst homogene Stromdichte auch innerhalb der Übergangskonturen 7, 8 zu gewährleisten.

In den Stirnflächen der beiden Anschlussteile 2,3 befindet sich jeweils eine koaxiale, zentrische Sackbohrung 9, 10 mit einem Innengewinde, wobei die beiden Sackbohrungen 9, 10 jeweils den Anschluss von Kabeln ermöglichen.

Darüber hinaus weisen die beiden Anschlussteile 2, 3 in ihrer Mantelfläche jeweils eine Längsnut 11, 12 auf, die eine Verdrehsicherung ermöglicht.

In den Übergangskonturen 7, 8 der beiden Anschlussteile 2, 3 befinden sich weiterhin mehrere radial verlaufende Sackbohrungen 13, 14, 15 und 16, die eine Gehäusemontage ermöglichen, wie noch detailliert erläutert wird.

Der Querschnitt des Widerstandselements 4 und der angrenzenden Bereiche der beiden Anschlussteile 2, 3 ist nicht exakt kreisförmig. Vielmehr weist der Strommesswiderstand 1 mittig insgesamt sechzehn Abplattungen 17 auf, die über den Umfang verteilt äquidistant angeordnet sind. Das Widerstandselement 4 weist also in einem Querschnitt rechtwinklig zur Stromflussrichtung einen Polygonquerschnitt mit sechzehn Ecken auf. Die Abplattungen 17 dienen zur Montage einer flexiblen Leiterplatte 18, die entsprechend der Anzahl der Abplattungen 17 mehrfach geknickt ist. Zwischen den einzelnen Knickstellen der Leiterplatte 18 liegen dabei jeweils ebene Leiterplattenabschnitte, die jeweils planparallel auf einer der Abplattungen 17 aufliegen.

Die Leiterplatte 18 weist auf ihrer den Anschlussteilen 2, 3 zugewandten Innenseite sechzehn Paare von Spannungsabgriffen 19, 20 auf, die durchkontaktiert sind und auf den Anschlussteilen 2, 3 aufliegen und deshalb jeweils paarweise den Spannungsabfall über dem Widerstandselement 4 messen.

Die Leiterplatte 18 mit den Spannungsabgriffen 19, 20 ist hierbei durch eine Ultraschallschweißverbindung mit den Anschlussteilen 2, 3 verbunden.

In den beiden Anschlussteilen 2, 3 befinden sich weiterhin zwei Ringnuten 21, 22, die ebenfalls einen Polygonquerschnitt mit sechzehn Ecken aufweisen. Dieser Polygonquerschnitt der Ringnuten 21, 22 ermöglicht bei der automatisierten Herstellung eine exakte Winkelausrichtung und dient als Fertigungshilfe bei der Montage der Leiterplatte 18.

Es wurde bereits vorstehend erwähnt, dass der Strommesswiderstand 1 zur Hochstrommessung in einem Hochspannungsnetz dient. Zur Erreichung einer ausreichenden Stromtragfähigkeit und einer entsprechend großen Kurzschlussfestigkeit weist der Strommesswiderstand 1 große Abmessungen und relativ große Massen auf. So beträgt die axiale Gesamtlänge des Strommesswiderstands 1 640 mm. Die Anschlussteile 2, 3 haben jeweils eine Masse von ca. 18 - 22 kg, während die Masse des Widerstandselements 4 ungefähr 2,5 kg beträgt. Der Außendurchmesser d2 beträgt ca. 10 cm, während der Außendurchmesser d1 der Anschlussteile 2, 3 entsprechend kleiner ist.

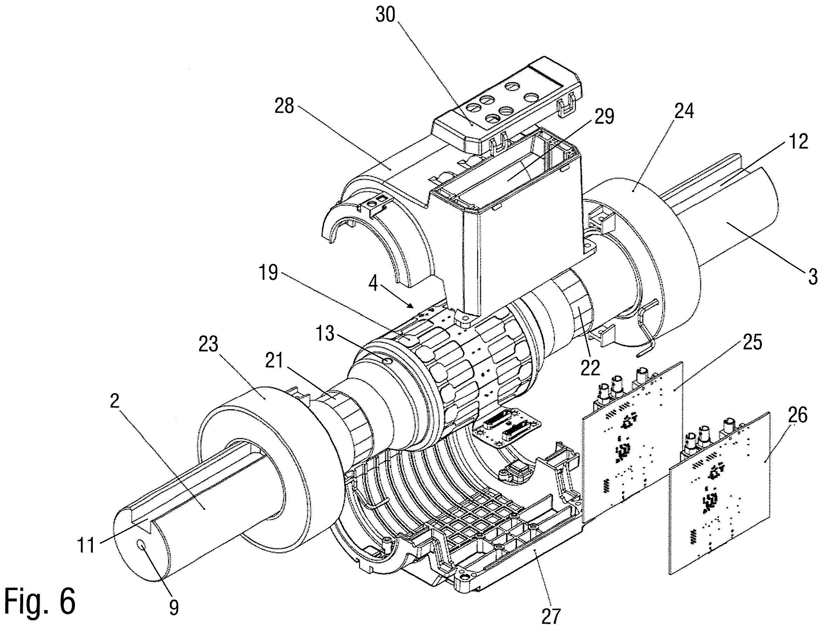

Aus der Explosionsdarstellung in Figur 6 ist weiterhin ersichtlich, dass die Anschlussteile 2, 3 von jeweils einer Energy-Harvesting-Spule 23, 24 umgeben sind, die aus dem Magnetfeld des Strommesswiderstands 1 elektrische Energie zum Betrieb von Messschaltungen gewinnt.

Die Messschaltungen sind redundant auf zwei Messkarten 25, 26 angeordnet, die mit der Leiterplatte 18 durch eine Leitung verbunden sind.

Weiterhin ist zu erwähnen, dass die Leiterplatte 18 neben den Spannungsabgriffen 19, 20 zusätzlich auch Gewichtungswiderstände trägt, um die Spannungsmesswerte der einzelnen Paare von Spannungsabgriffen 19, 20 zu gewichten. Die gewichteten Spannungsmesswerte werden dann von der Leiterplatte 18 über die Leitung an die beiden Messkarten 25, 26 weitergeleitet und dort verarbeitet.

Die Messkarten 25, 26 tragen auch eine elektro-optische Datenschnittstelle, um Messdaten über einen Lichtwellenleiter an eine externe Auswertungseinheit zu übertragen.

Weiterhin ist aus der Explosionsdarstellung ersichtlich, dass der Strommesswiderstand 1 zwei Gehäuseteile 27, 28 aufweist, die an den Sackbohrungen 13-16 in dem Strommesswiderstand 1 befestigt werden können.

Das Gehäuseteil 28 bildet hierbei ein Einschubfach 29 für die beiden Messkarten 25, 26, wobei das Einschubfach 29 durch einen Deckel 30 verschlossen werden kann.

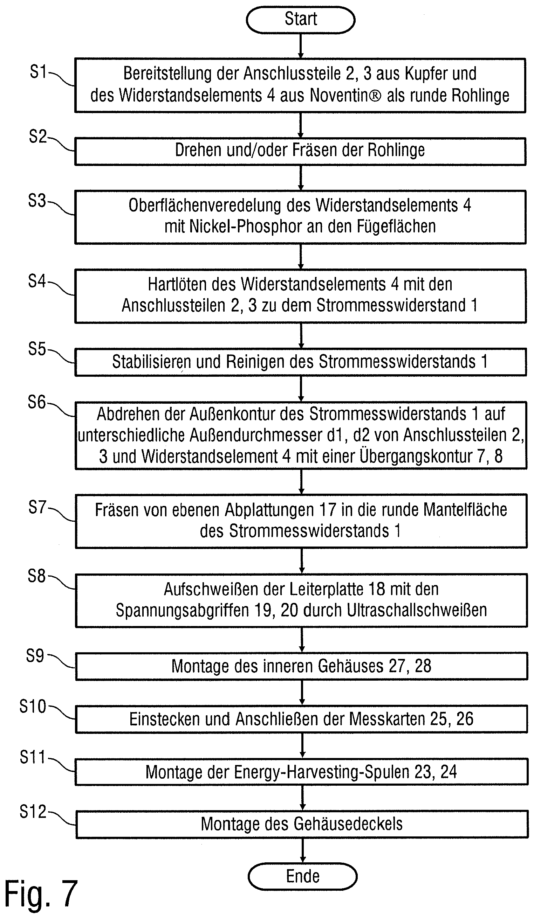

Im Folgenden wird nun unter Bezugnahme auf das Flussdiagramm gemäß Figur 7 das erfindungsgemäße Herstellungsverfahren beschrieben.

In einem ersten Schritt S1 werden zunächst die beiden Anschlussteile 2, 3 aus Kupfer und das Widerstandselement 4 aus Noventin^{®} als runde Rohlinge bereitgestellt.

In einem weiteren Schritt S2 werden dann die Rohlinge gedreht und/oder gefräst.

Im nächsten Schritt S3 erfolgt dann die Oberflächenveredelung des Widerstandselements an den Fügeflächen, um die Oberflächenveredelung 5, 6 aufzubringen.

Nach dieser Oberflächenveredelung kann dann in einem Schritt S4 der Hartlötprozess beginnen, um das Widerstandselement 4 mit den Anschlussteilen 2, 3 zusammenzufügen.

In einem nächsten Schritt S5 wird der Strommesswiderstand 1 dann stabilisiert und gereinigt.

Anschließend wird der Strommesswiderstand 1 in einem Schritt S6 abgedreht, um die gewünschte Außenkontur mit den Außendurchmessern d1, d2 zu erreichen.

In einem weiteren Schritt S7 werden dann die Abplattungen 17 in die runde Mantelfläche des Strommesswiderstands 1 gefräst.

Danach wird dann in einem Schritt S8 die Leiterplatte 18 durch Ultraschallschweißen an der Mantelfläche des Strommesswiderstands 1 befestigt.

In einem Schritt S9 erfolgt dann die Montage eines Gehäuses, das aus den beiden Gehäuseteilen 27, 28 besteht.

Danach werden in einem Schritt S10 die beiden Messkarten 25, 26 in das Einschubfach 29 eingesteckt.

In einem Schritt S11 erfolgt dann die Montage der Energy-Harvesting-Spulen 23, 24.

Schließlich erfolgt dann in einem Schritt S12 die Montage des Gehäusedeckels.

### Bezugszeichenliste:

- 1: Strommesswiderstand
- 2, 3: Anschlussteile zur Einleitung bzw. Ausleitung des zu messenden Stroms
- 4: Widerstandselement
- 5, 6: Oberflächenveredelung an den Fügeflächen des Widerstandselements
- 7, 8: Übergangskontur zwischen Anschlussteilen und Widerstandselement
- 9, 10: Axiale Sackbohrungen in den Stirnflächen der Anschlussteile
- 11, 12: Längsnuten in den Anschlussteilen
- 13-16: Sackbohrungen zur Gehäusemontage
- 17: Abplattungen
- 18: Flexible Leiterplatte
- 19, 20: Spannungsabgriffe
- 21, 22: Ringnuten in den Anschlussteilen
- 23, 24: Energy-Harvesting-Spule zur Energiegewinnung durch Energy Harvesting
- 25, 26: Messkarten
- 27, 28: Gehäuseteile
- 29: Einschubfach für die Messkarten
- 30: Deckel des Einschubfachs
- d1: Durchmesser im Bereich der Anschlussteile
- d2: Durchmesser im Bereich des Widerstandselements

## Patentansprüche

1. Strommesswiderstand (1) zur Messung eines elektrischen Stroms (I_{AC}), insbesondere im kA-Bereich in einem Hochspannungsnetz, mit
a) einem ersten Anschlussteil (2) aus einem Leitermaterial zur Einleitung des elektrischen Stroms (I_{AC}) in den Strommesswiderstand (1),
b) einem zweiten Anschlussteil (3) aus einem Leitermaterial zur Ausleitung des elektrischen Stroms (I_{AC}) aus dem Strommesswiderstand (1), und
c) einem Widerstandselement (4) aus einem niederohmigen Widerstandsmaterial, wobei das Widerstandselement (4) in Stromflussrichtung zwischen dem ersten Anschlussteil (2) und dem zweiten Anschlussteil (3) angeordnet und mit den beiden Anschlussteilen (2, 3) zusammengefügt ist, so dass der zu messende elektrische Strom (I_{AC}) im Betrieb durch das Widerstandselement (4) fließt und einen Spannungsabfall (U_{MESS}) über dem Widerstandselement (4) erzeugt,
d) einer Leiterplatte (18), die auf der Mantelfläche des Strommesswiderstands (1) befestigt ist, um den Spannungsabfall (U_{MESS}) über dem Widerstandselement (4) zu messen,
e) wobei das erste Anschlussteil (2), das zweite Anschlussteil (3) und das Widerstandselement (4) jeweils in einer Schnittebene rechtwinklig zur Stromflussrichtung des elektrischen Stroms (I_{AC}) einen im Wesentlichen runden Querschnitt haben, insbesondere einen im Wesentlichen kreisrunden Querschnitt,
**dadurch gekennzeichnet,**
f) dass die Leiterplatte (18) eine flexible Leiterplatte (18) ist, die entsprechend der Außenkontur des Strommesswiderstands (1) in Umfangsrichtung gewölbt oder geknickt ist.

2. Strommesswiderstand (1) nach Anspruch 1, **dadurch gekennzeichnet,**
a) **dass** das runde Widerstandselement (4) einen Außendurchmesser (d2) aufweist, der größer ist als der Außendurchmesser (d1) der beiden runden Anschlussteile (2, 3), und/oder
b) **dass** das runde Widerstandselement (4) bezüglich der Stromflussrichtung mittig zwischen den beiden Anschlussteilen (2, 3) angeordnet ist, und/oder
c) **dass** der Strommesswiderstand (1) zwischen den beiden äußeren Anschlussteilen (2, 3) mit dem kleineren Außendurchmesser (d1) und dem mittigen runden Widerstandselement (4) mit derr größeren Außendurchmesser (d2) eine Übergangskontur (7, 8) aufweist,
d) **dass** die Übergangskontur (7, 8) vorzugsweise glatt und knickfrei ist, um eine homogene Stromverteilung zu erreichen,
e) **dass** sich die Übergangskontur (7, 8) vorzugsweise ausschließlich in den Anschlussteilen (2, 3) befindet, und/oder
f) **dass** die Übergangskontur (7, 8) mindestens teilweise konkav ist.

3. Strommesswiderstand (1) nach einem der vorhergehenden Ansprüche, **dadurch gekennzeichnet, dass** das runde Widerstandselement (4) durch eine der folgenden Verbindungsarten mit derr ersten Anschlussteil (2) und mit dem zweiten Anschlussteil (3) zusammengefügt ist:
a) Lötverbindung, insbesondere Hartlötverbindung, insbesondere Vakuumhartlötverbindung.
b) Schweißverbindung, insbesondere Elektronenstrahlschweißverbindung,

4. Strommesswiderstand (1) nach einem der vorhergehenden Ansprüche, **dadurch gekennzeichnet, dass** das runde Widerstandselement (4) an den Fügestellen zu den beiden Anschlussteilen (2, 3] eine schichtförmige Oberflächenveredelung (5, 6) aufweist, insbesondere mit Nickel, Nickel-Phosphor, Gold oder Silber als Inhaltsstoffen.

5. Strommesswiderstand (1) nach einem der vorhergehenden Ansprüche,
**dadurch gekennzeichnet,**
a) **dass** die Leiterplatte (18) in axialer Richtung im Bereich des runden Widerstandselements (4) angeordnet ist und sich in axialer Richtung beidseitig bis über die Mantelfläche der beiden Anschlussteile (2, 3) erstreckt, und/oder
b) **dass** die Leiterplatte (18) durch eine Lötverbindung oder eine Schweißverbindung mit dem Strommesswiderstand (1) verbunden ist, insbesondere durch
d1) eine Ultraschallschweißverbindung oder
d2) eine Laserschweißverbindung, und/oder
c) **dass** die Schweißverbindung der Leiterplatte (18) im Bereich der Anschlussteile (2, 3) und/oder im Bereich des runden Widerstandselements (4) liegt, und/oder
d) **dass** die Leiterplatte (18) mindestens zwei Leiterplattenlagen aufweist, und/oder
e) **dass** die Leiterplatte (18) zur Messung der Temperatur des Widerstandsmaterials auch einen Temperatursensor trägt, insbesondere einen NTC-Widerstand oder einen PTC-Widerstand.

6. Strommesswiderstand (1) nach Anspruch 5, **dadurch gekennzeichnet,**
a) **dass** mehrere Paare von Spannungsabgriffen (19, 20) vorgesehen sind, wobei jedes Paar von Spannungsabgriffen (19, 20) den Spannungsabfall (U_{MESS}) über dem runden Widerstandselement (4] misst und einen entsprechenden Spannungsmesswert liefert, und
b) **dass** die mehreren Paare von Spannungsabgriffen (19, 20) über den Umfang des Strommesswiderstands (1) verteilt angeordnet sind, um den Spannungsabfall (U_{MESS}) über dem runden Widerstandselement (4) an mehreren verschiedenen Stellen verteilt über den Umfang des Strommesswiderstands (1) zu messen,
c) **dass** die Anzahl der mehreren Paare von Spannungsabgriffen (19, 20) größer ist als 2, 4, 8, 12, 14, insbesondere mit genau 16 Paaren von Spannungsabgriffen (19, 20), und/oder
d) **dass** die Spannungsabgriffe direkt an der Leiterplatte (18) angebracht sind und direkt auf der Mantelfläche der Anschlussteile (2, 3) aufliegen, und/oder
e) **dass** die Paare von Spannungsabgriffen (19, 20) jeweils mit Gewichtungswiderständen verbunden sind, um die einzelnen Spannungsmesswerte entsprechend dem Widerstandswert der Gewichtungswiderstände zu gewichten, und
f) **dass** die Gewichtungswiderstände auf der Leiterplatte (18) angeordnet sind.

7. Strommesswiderstand (1) nach Anspruch 6,
**dadurch gekennzeichnet,**
a) **dass** die mehreren Paare von Spannungsabgriffen (19, 20) mit einer Messschaltung verbunden sind, die aus den Messwerten den Spannungsabfall (U_{MESS}) über dem Widerstandselement (4) ermittelt, und
b) **dass** die Messschaltung den Spannungsabfall (U_{MESS}) über dem Widerstandselement (4) aus den gewichteten Spannungsmesswerten berechnet, und/oder
c) **dass** die Messschaltung nicht auf der Leiterplatte (18) angeordnet ist, sondern auf mindestens einer separaten Messkarte (25, 26), die durch eine Leitung mit der Leiterplatte (18) verbunden ist, und/oder
d) **dass** die Messschaltung mit einer Datenschnittstelle verbunden ist, um Messwerte des Spannungsabfalls (U_{MESS}) an eine externe Auswertungseinheit zu übertragen,
e) **dass** die Datenschnittstelle vorzugsweise eine elektro-optische Datenschnittstelle ist, welche die Messwerte über einen Lichtwellenleiter an die externe Auswertungseinheit überträgt, und/oder
f) **dass** zur Schaffung von Redundanz bei der Messung zwei Messkarten (25, 26) vorgesehen sind, die jeweils eine Messschaltung aufweisen, und/oder
g) **dass** die Messschaltung mindestens zwei oder mindestens drei Messpfade aufweist, wobei die einzelnen Messpfade jeweils die Messwerte für den Spannungsabfall über dem runden Widerstandselement (4) von der Leiterplatte (18) aufnehmen, und/oder
h) **dass** der erste Messpfad und der zweite Messpfad die gleiche Signalverstärkung aufweisen, während der dritte Messpfad eine geringere Signalverstärkung aufweist.

8. Strommesswiderstand (1) nach einem der Ansprüche 5 bis 7,
**dadurch gekennzeichnet,**
a) **dass** die im Wesentlichen runde Außenkontur des Strommesswiderstands (1) mindestens eine ebene Abplattung (17) in der Mantelfläche des Strommesswiderstands (1) aufweist, um die Leiterplatte (18) planparallel auf der Abplattung (17) zu montieren, und/oder
b) **dass** über den Umfang des Strommesswiderstands (1) verteilt mehrere Abplattungen (17) in der Mantelfläche des Strommesswiderstands (1) angeordnet sind, insbesondere mindestens 2, 4, 6, 8, 10, 12 oder 14, vorzugsweise genau 16, und
c) **dass** sich die Abplattungen (17) in der Mantelfläche des runden Widerstandselements (4) befinden, und/oder
d) **dass** sich die Abplattungen (17) in Stromflussrichtung beidseitig bis in die Anschlussteile (2, 3) erstrecken, und/oder
e) **dass** die Leiterplatte (18) entsprechend der Anzahl der Abplattungen (17) mehrfach geknickt ist und mehrere ebene Leiterplattenabschnitte aufweist, die jeweils planparallel auf einer der Abplattungen (17) montiert sind.

9. Strommesswiderstand (1) nach einem der vorhergehenden Ansprüche,
**dadurch gekennzeichnet,**
a) **dass** zur Energiegewinnung aus dem Magnetfeld des Strommesswiderstands (1) durch Energy-Harvesting mindestens eine Spule (23, 24) vorgesehen ist, und
b) **dass** die Spule (23, 24) die zum Betrieb der Messschaltung benötigte elektrische Energie liefert, insbesondere allein oder mit einer zusätzlichen Energieversorgung, und/oder
c) **dass** die Spule (23, 24) mindestens 20, 50, 100, 140 Windungen aufweist, insbesondere genau 150 Windungen, und/oder
d) **dass** die Spule (23, 24) einen Magnetkern enthält, und/oder
e) **dass** zum Energy-Harvesting mehrere Spulen (23, 24) vorgesehen sind, die jeweils eines der beiden Anschlussteile (2, 3) ringförmig umgeben, und/oder
f) **dass** ein Stromspeicher in den Strommesswiderstand (1) integriert ist, insbesondere mindestens ein Power-Cap mit einer Kapazität von mindestens 10 mF, 50 mF, 100 mF, 500 mF oder mindestens 1.000 mF, und/oder
g) **dass** zur alleinigen oder unterstützenden Stromversorgung eine Photozelle in den Strommesswiderstand (1) integriert ist.

10. Strommesswiderstand (1) nach einem der vorhergehenden Ansprüche,
**dadurch gekennzeichnet,**
a) **dass** das Leitermaterial Kupfer oder eine Kupferlegierung ist, und/oder
b) **dass** das Leitermaterial der Anschlussteile (2, 3) einen geringeren spezifischen elektrischen Widerstand hat als das Widerstandsmaterial des runden Widerstandselements (4), und/oder
c) **dass** das Widerstandsmaterial des runden Widerstandselements (4) eine Kupfer-Mangan-Nickel-Legierung ist, insbesondere
c1) mit 25 Gewichtsprozent Mangan, 10 Gewichtsprozent Nickel und dem Rest Kupfer, oder
c2) mit 12 Gewichtsprozent Mangan, 2 Gewichtsprozent Nickel und dem Rest Kupfer, und/oder
d) **dass** das Widerstandsmaterial des runden Widerstandselements (4) einen spezifischen elektrischen Widerstand von weniger als 1000 µΩcm, 500 µΩcm, 250 µΩcm, 100 µΩcm oder 50 µΩcm aufweist, und/oder
e) **dass** das Leitermaterial einen spezifischen elektrischen Widerstand von weniger als 20 µΩcm, 10 µΩcm, 5 µΩcm oder 2 µΩcm aufweist, und/oder
f) **dass** das runde Widerstandselement (4), das erste Anschlussteil und/oder das zweite Anschlussteil ohne Hohlräume massiv ausgeführt sind, und/oder
g) **dass** die Anschlussteile (2, 3) in ihrer Mantelfläche jeweils eine axial verlaufende Längsnut (11, 12) aufweisen, die von der Stirnfläche der Anschlussteile (2, 3) ausgeht, und/oder
h) **dass** die beiden Anschlussteile (2, 3) in ihrer Mantelfläche jeweils mindestens eine radial verlaufende Sackbohrung (13-16) zur Gehäusemontage aufweisen, insbesondere in der Übergangskontur (7, 8), und/oder
i) **dass** die beiden Anschlussteile (2, 3) in ihren Stirnfläche jeweils eine axial verlaufende Sackbohrung (9, 10) aufweisen, insbesondere mit einem Innengewinde, insbesondere zentrisch und koaxial, und/oder
j) **dass** die beiden Anschlussteile (2, 3) in ihrer Mantelfläche jeweils eine umlaufende Ringnut (21, 22) mit einem Polygonquerschnitt aufweisen, der als Fertigungshilfe dient, und/oder
k) **dass** der Außendurchmesser (d2) des runden Widerstandselements (4) mindestens 6cm, 7cm, 8cm oder 9cm, insbesondere im Wesentlichen 10cm beträgt, und/oder
l) dass der Außendurchmesser (d1) der runden Anschlussteile (2, 3) mindestens 2 cm, 3 cm, 4 cm oder 5 cm beträgt, und/oder
m) **dass** der Strommesswiderstand (1) in Stromflussrichtung eine axiale Länge von mindestens 10 cm, 20 cm, 30 cm, 40 cm, 50 cm oder 60 cm aufweist, insbesondere im Wesentlichen 64cm, und/oder
n) **dass** das runde Widerstandselement (4) in Stromflussrichtung eine axiale Länge von mindestens 1 cm, 2 cm, 3 cm, 4 cm, 5 cm oder 6 cm aufweist, insbesondere im Wesentlichen 7 cm, und/oder
o) **dass** die beiden Anschlussteile (2, 3) in Stromflussrichtung jeweils eine axiale Länge von mindestens 10 cm, 20 cm, 25 cm oder 30 cm aufweisen, insbesondere im Wesentlichen 31 cm, und/oder
p) **dass** die beiden Anschlussteile (2, 3) jeweils eine Masse von mindestens 1kg, 2kg, 5kg, 10kg, 15kg oder 20kg haben, insbesondere im Wesentlichen 22kg, und/oder
q) **dass** das runde Widerstandselement (4) eine Masse von mindestens 0,5 kg, 1 kg, 1,5 kg oder 2 kg aufweist, insbesondere im Wesentlichen 2,5 kg, und/oder
r) **dass** der Strommesswiderstand (1) bei Wechselstrom eine Dauerstrombelastbarkeit von mindestens 1 kA, 5 kA, 10 kA, 25 kA, 50 kA, 75 kA, 9 5kA oder mindestens 100 kA aufweist, und/oder
s) **dass** der Strommesswiderstand (1) bei Wechselstrom für ein Spannungsniveau von mindestens 1 kV, 5 kV, 10 kV, 50 kV, 110 kV, 220 kV oder mindestens 380 kV geeignet ist, und/oder
t) **dass** das erste Anschlussteil, das zweite Anschlussteil und/oder das runde Widerstandselement (4) jeweils in einer Schnittebene rechtwinklig zur Stromflussrichtung des elektrischen Stroms (I_{AC}) einen polygonalen Querschnitt haben mit mindestens 12, 14 oder 16 Ecken, um den im Wesentlichen runden Querschnitt zu bilden.

11. Herstellungsverfahren für einen Strommesswiderstand (1), insbesondere für einen Strommesswiderstand (1) zur Strommessung im kA-Bereich in einem Hochspannungsnetz, insbesondere für einen Strommesswiderstand (1) nach einem der vorhergehenden Ansprüche, mit den folgenden Schritten:
a) Bereitstellung eines ersten Anschlussteils (2) aus einem Leitermaterial zur Einleitung des elektrischen Stroms (I_{AC}) in den Strommesswiderstand (1),
b) Bereitstellung eines zweiten Anschlussteils (3) aus einem Leitermaterial zur Ausleitung des elektrischen Stroms (I_{AC}) aus dem Strommesswiderstand (1),
c) Bereitstellung eines Widerstandselements (4) aus einem niederohmigen Widerstandsmaterial,
d) Zusammenfügen des Widerstandselements (4) mit den beiden Anschlussteilen (2, 3) zu dem Strommesswiderstand (1), so dass das Widerstandselement (4) in Stromflussrichtung zwischen dem ersten Anschlussteil (2) und dem zweiten Anschlussteil (3) angeordnet ist und der zu messende elektrische Strom (I_{AC}) im Betrieb durch das Widerstandselement (4) fließt und einen Spannungsabfall (U_{MESS}) über dem Widerstandselement (4) erzeugt,
e) Befestigen einer Leiterplatte (18) auf der Mantelfläche des Strommesswiderstands (1), um den Spannungsabfall (U_{MESS}) über dem Widerstandselement (4) zu messen,
f) wobei das erste Anschlussteil (2), das zweite Anschlussteil (3) und das Widerstandselement (4) jeweils in einer Schnittebene rechtwinklig zur Stromflussrichtung einen im Wesentlichen runden Querschnitt haben, insbesondere einen im Wesentlichen kreisrunden Querschnitt,
**dadurch gekennzeichnet,**
g) dass die Leiterplatte (18) eine flexible Leiterplatte (18) ist, die entsprechend der Außenkontur des Strommesswiderstands (1) in Umfangsrichtung gewölbt oder geknickt ist.

12. Herstellungsverfahren nach Anspruch 11, **dadurch gekennzeichnet, dass** das Zusammenfügen des runden Widerstandselements (4) mit den beiden Anschlussteilen (2, 3) durch eines der folgenden Fügeverfahren erfolgt:
a) Löten, insbesondere Hartlöten, insbesondere Vakuumhartlöten,
b) Schweiß, insbesondere Elektronenstrahlschweißen,

13. Herstellungsverfahren nach Anspruch 12, **gekennzeichnet durch** folgenden Schritt vor dem Zusammenfügen des runden Widerstandselements (4) mit den beiden Anschlussteilen (2, 3):
Oberflächenveredelung der Fügefläche, insbesondere **durch** eine Beschichtung (5, 6) mit Nickel, Nickel-Phosphor, Gold und/oder Silber als Inhaltsstoffen.

14. Herstellungsverfahren nach einem der Ansprüche 11 bis 13, **gekennzeichnet durch** folgende Schritte nach dem Zusammenfügen des Widerstandselements (4) mit den beiden Anschlussteilen (2, 3):
a) Formen der Außenkontur des Strommesswiderstands (1), insbesondere **durch** Drehen oder Fräsen,
a1) insbesondere mit einem größeren Außendurchmesser (d2) bei dem mittigen runden Widerstandselement (4) als bei den äußeren Anschlussteilen (2, 3),
a2) insbesondere mit einer Übergangskontur (7, 8) zwischen den beiden äußeren Anschlussteilen (2, 3) mit dem kleineren Außendurchmesser (d1) und dem mittigen runden Widerstandselement (4) mit dem größeren Außendurchmesser (d2), und/oder
b) Formen von mindestens einer ebenen Abplattung (17) in der Mantelfläche des Strommesswiderstands (1) zur planparallelen Montage einer Leiterplatte (18) auf der Abplattung (17), wobei vorzugsweise
b1) zahlreiche Abplattungen (17) über den Umfang des Strommesswiderstands (1) verteilt in der Mantelfläche des Strommesswiderstands (1) geformt werden, und
b2) die Leiterplatte (18) entsprechend der Anzahl der Abplattungen (17) mehrfach geknickt ist und mehrere ebene Leiterplattenabschnitte aufweist, und
b3) die einzelnen ebenen Leiterplattenabschnitte jeweils planparallel auf einer der Abplattungen (17) des Strommesswiderstands (1) montiert sind.

15. Herstellungsverfahren nach einem der Ansprüche 11 bis 14, **gekennzeichnet durch** folgenden Schritt:
a) Befestigung einer Leiterplatte (18) zur Messung des Spannungsabfalls über dem runden Widerstandselement (4) auf der Mantelfläche des Widerstandselements (4), insbesondere **durch** eine Schweißverbindung, und/oder
b) Montage eines Gehäuses (27, 28) auf dem Strommesswiderstand (1), wobei das Gehäuse das runde Widerstandselement (4) einschließt, und
c) Einführen von mindestens einer Messkarte (25, 26) in das Gehäuse (27, 28), wobei die Messkarte (25, 26) den Spannungsabfall (U_{MESS}) über dem runden Widerstandselement (4) misst, und/oder
d) Montage mindestens einer Spule (23, 24) zur Energiegewinnung aus dem Magnetfeld des Strommesswiderstands (1) **durch** Energy-Harvesting, und/oder
e) Montage eines Gehäusedeckels auf dem Strommesswiderstand (1).

## Claims

1. Current measuring resistor (1) for measuring an electric current (I_{AC}), in particular in the kA range in a high-voltage network, having
a) a first connection part (2) made of a conductor material for introducing the electric current (I_{AC}) into the current measuring resistor (1),
b) a second connection part (3) made of a conductor material for conducting the electric current (I_{AC}) out of the current measuring resistor (1), and
c) a resistor element (4) made of a low-resistance resistance material, the resistor element (4) being arranged in the direction of current flow between the first connection part (2) and the second connection part (3) and being joined to the two connection parts (2, 3) so that the electric current (I_{AC}) to be measured flows through the resistor element (4) during operation and produces a voltage drop (U_{MESS}) across the resistor element (4),
d) a printed circuit board (18) which is attached to the outer surface of the current measuring resistor (1) in order to measure the voltage drop (U_{MESS}) across the resistor element (4),
e) wherein the first connection part (2), the second connection part (3) and the resistor element (4) each have a substantially round cross-section, in particular a substantially circular cross-section, in a sectional plane at right angles to the direction of flow of the electric current (I_{AC}),
**characterized in**
f) that the printed circuit board (18) is a flexible printed circuit board (18) which is curved or bent in the circumferential direction in accordance with the outer contour of the current measuring resistor (1).

2. Current measuring resistor (1) according to claim 1, **characterized in**
a) **that** the round resistor element (4) has an outer diameter (d2) which is larger than the outer diameter (d1) of the two round connection parts (2, 3), and/or
b) **that** the round resistor element (4) is arranged centrally between the two connection parts (2, 3) with respect to the current flow direction, and/or
c) **that** the current measuring resistor (1) has a transition contour (7, 8) between the two outer connection parts (2, 3) with the smaller outer diameter (d1) and the central round resistor element (4) with the larger outer diameter (d2),
d) **that** the transition contour (7, 8) is preferably smooth and kink-free in order to achieve a homogeneous current distribution,
e) **that** the transition contour (7, 8) is preferably located exclusively in the connection parts (2, 3), and/or
f) **that** the transition contour (7, 8) is at least partially concave.

3. Current measuring resistor (1) according to one of the preceding claims, **characterized in that** the round resistor element (4) is joined to the first connection part (2) and to the second connection part (3) by one of the following connection types:
a) Soldered connection, in particular hard soldered connection, in particular vacuum hard soldered connection.
b) Welded connection, in particular electron beam welded connection,

4. Current measuring resistor (1) according to one of the preceding claims, **characterized in that** the round resistor element (4) has a layered surface finish (5, 6) at the joints to the two connection parts (2, 3), in particular with nickel, nickel-phosphorus, gold or silver as ingredients.

5. Current measuring resistor (1) according to one of the preceding claims,
**characterized in**
a) **that** the printed circuit board (18) is arranged in the axial direction in the region of the round resistor element (4) and extends in the axial direction on both sides as far as over the outer surface of the two connection parts (2, 3), and/or
b) **that** the printed circuit board (18) is connected to the current measuring resistor (1) by a solder joint or a weld joint, in particular by
d1) an ultrasonic welding connection or
d2) a laser welded connection, and/or
c) **that** the weld joint of the printed circuit board (18) is located in the region of the connection parts (2, 3) and/or in the region of the round the resistor element (4), and/or
d) **that** the printed circuit board (18) has at least two printed circuit board layers, and/or
e) **that** the printed circuit board (18) also carries a temperature sensor, in particular an NTC resistor or a PTC resistor, for measuring the temperature of the resistance material.

6. Current measuring resistor (1) according to claim 5, **characterized in,**
a) **that** several pairs of voltage taps (19, 20) are provided, each pair of voltage taps (19, 20) measuring the voltage drop (U_{MESS}) across the round resistor element (4) and providing a corresponding voltage reading, and
b) **that** the several pairs of voltage taps (19, 20) are arranged distributed over the circumference of the current-measuring resistor (1) in order to measure the voltage drop (U_{MESS}) across the round resistor element (4) at a plurality of different points distributed over the circumference of the current-measuring resistor (1),
c) **that** the number of the several pairs of voltage taps (19, 20) is greater than 2, 4, 8, 12, 14, in particular with exactly 16 pairs of voltage taps (19, 20), and/or
d) **that** the voltage taps are attached directly to the printed circuit board (18) and rest directly on the outer surface of the connection parts (2, 3), and/or
e) **that** the pairs of voltage taps (19, 20) are each connected to weighting resistors in order to weight the individual voltage measurement values in accordance with the resistance value of the weighting resistors, and
f) **that** the weighting resistors are arranged on the printed circuit board (18).

7. Current measuring resistor (1) according to claim 6,
**characterized in**
a) **that** the several pairs of voltage taps (19, 20) are connected to a measuring circuit which determines the voltage drop (U_{MESS}) across the resistor element (4) from the measured values, and
b) **that** the measuring circuit calculates the voltage drop (U_{MESS}) across the resistor element (4) from the weighted voltage measured values, and/or
c) **that** the measuring circuit is not arranged on the printed circuit board (18) but on at least one separate measuring card (25, 26) which is connected to the printed circuit board (18) by a line, and/or
d) **that** the measuring circuit is connected to a data interface in order to transmit measured values of the voltage drop (U_{MESS}) to an external evaluation unit,
e) **that** the data interface is preferably an electro-optical data interface which transmits the measured values to the external evaluation unit via an optical waveguide, and/or
f) **that**, in order to create redundancy in the measurement, two measurement cards (25, 26) are provided, each of which has a measurement circuit, and/or
g) **that** the measuring circuit has at least two or at least three measuring paths, where the individual measuring paths each receive the measured values for the voltage drop across the round resistor element (4) from the printed circuit board (18), and/or
h) **that** the first measurement path and the second measurement path have the same signal amplification, while the third measurement path has a lower signal amplification.

8. Current measuring resistor (1) according to any one of claims 5 to 7,
**characterized in**
a) **that** the essentially round outer contour of the current-measuring resistor (1) has at least one flat flattening (17) in the lateral surface of the current-measuring resistor (1) in order to mount the printed circuit board (18) in a plane-parallel manner on the flattening (17), and
b) **that** a plurality of flattenings (17) are distributed over the circumference of the current-measuring resistor (1) in the lateral surface of the current-measuring resistor (1), in particular at least 2, 4, 6, 8, 10, 12 or 14, preferably exactly 16, and
c) **that** the flattenings (17) are located in the outer surface of the resistor element (4), and/or
d) **that** the flattenings (17) extend in the direction of current flow on both sides into the connection parts (2, 3), and/or
e) **that** the printed circuit board (18) is bent several times in accordance with the number of flattenings (17) and has a plurality of flat printed circuit board sections which are each mounted plane-parallel on one of the flattenings (17).

9. Current measuring resistor (1) according to one of the preceding claims,
**characterized in**
a) **that** at least one coil (23, 24) is provided for energy harvesting from the magnetic field of the current measuring resistor (1) by energy harvesting, and
b) **that** the coil (23, 24) supplies the electrical energy required for operating the measuring circuit, in particular alone or with an additional energy supply, and/or
c) **that** the coil (23, 24) has at least 20, 50, 100, 140 windings, in particular exactly 150 windings, and/or
d) **that** the coil (23, 24) contains a magnetic core, and/or
e) **that**, for energy harvesting, a plurality of coils (23, 24) are provided, each of which annularly surrounds one of the two connection parts (2, 3), and/or
f) **that** a current storage device is integrated into the current measuring resistor (1), in particular at least one power cap with a capacitance of at least 10 mF, 50 mF, 100 mF, 500 mF or at least 1,000 mF, and/or
g) **that** a photocell is integrated into the current measuring resistor (1) for the sole or supporting power supply.

10. Current measuring resistor (1) according to any one of the preceding claims,
**characterized in**
a) **that** the conductor material is copper or a copper alloy, and/or
b) **that** the conductor material of the connection parts (2, 3) has a lower specific electrical resistance than the resistance material of the round resistor element (4), and/or
c) **that** the resistance material of the round resistor element (4) is a copper-manganese-nickel alloy, in particular
c1) with 25 weight percent manganese, 10 weight percent nickel and the remainder copper, or
c2) with 12 weight percent manganese, 2 weight percent nickel and the remainder copper, and/or
d) **that** the resistance material of the round resistor element (4) has a resistivity of less than 1000 cm, 500 µΩcm, 250 µΩcm, 100 µΩcm or 50 µΩcm, and/or
e) **that** the conductor material has a specific electrical resistance of less than 20 µΩcm, 10 µΩcm, 5 µΩcm or 2 µΩcm, and/or
f) **that** the round resistor element (4), the first connection part and/or the second connection part are of solid construction without cavities, and/or
g) **that** the connection parts (2, 3) each have an axially extending longitudinal groove (11, 12) in their lateral surface, which groove starts from the end face of the connection parts (2, 3), and/or
h) **that** the two connection parts (2, 3) each have in their lateral surface at least one radially extending blind bore (13-16) for housing assembly, in particular in the transition contour (7, 8), and/or
i) **that** the two connection parts (2, 3) each have in their end face an axially running blind bore (9, 10), in particular with an internal thread, in particular centrically and coaxially, and/or
j) **that** the two connection parts (2, 3) each have in their lateral surface a circumferential annular groove (21, 22) with a polygonal cross section which serves as a manufacturing aid, and/or
k) **that** the outer diameter (d2) of the round resistor element (4) is at least 6cm, 7cm, 8cm or 9cm, in particular substantially 10cm, and/or
l) that the outer diameter (d1) of the round connection parts (2, 3) is at least 2cm, 3cm, 4cm or 5cm, and/or
m) **that** the current measuring resistor (1) has an axial length in the direction of current flow of at least 10 cm, 20 cm, 30 cm, 40 cm, 50 cm or 60 cm, in particular essentially 64 cm, and/or
n) **that** the round resistor element (4) has an axial length in the direction of current flow of at least 1 cm, 2 cm, 3 cm, 4 cm, 5 cm or 6 cm, in particular essentially 7 cm, and/or
o) **that** the two connection parts (2, 3) each have an axial length in the direction of current flow of at least 10 cm, 20 cm, 25 cm or 30 cm, in particular essentially 31 cm, and/or
p) **that** the two connection parts (2, 3) each have a mass of at least 1kg, 2kg, 5kg, 10kg, 15kg or 20kg, in particular essentially 22kg, and/or
q) **that** the round resistor element (4) has a mass of at least 0.5kg, 1kg, 1.5kg or 2kg, in particular essentially 2.5kg, and/or
r) **that** the current measuring resistor (1) has a continuous current carrying capacity of at least 1 kA, 5 kA, 10 kA, 25 kA, 50 kA, 75 kA, 9 5kA or at least 100 kA for alternating current, and/or
s) **that** the current measuring resistor (1) is suitable for a voltage level of at least 1 kV, 5 kV, 10 kV, 50 kV, 110 kV, 220 kV or at least 380 kV for alternating current, and/or
t) **that** the first connection part, the second connection part and/or the round resistor element (4) each have a polygonal cross-section in a sectional plane at right angles to the direction of flow of the electric current (I_{AC}), with at least 12, 14 or 16 corners to form the substantially round cross-section.

11. Manufacturing method for a current measuring resistor (1), in particular for a current measuring resistor (1) for current measurement in the kA range in a high-voltage network, in particular for a current measuring resistor (1) according to one of the preceding claims, comprising the following steps:
a) providing a first connection part (2) made of a conductor material for introducing the electric current (I_{AC}) into the current measuring resistor (1),
b) providing a second connection part (3) made of a conductor material for conducting the electric current (I_{AC}) out of the current measuring resistor (1),
c) providing a resistor element (4) made of a low-resistance resistance material,
d) joining the resistor element (4) to the two connection parts (2, 3) to form the current-measuring resistor (1), so that the resistor element (4) is arranged in the direction of current flow between the first connection part (2) and the second connection part (3) and the electric current (I_{AC}) to be measured flows through the resistor element (4) during operation and generates a voltage drop (U_{MESS}) across the resistor element (4),
e) attachment of a printed circuit board (18) to the outer surface of the current measuring resistor (1) in order to measure the voltage drop (U_{MESS}) across the resistor element (4),
f) wherein the first connection part (2), the second connection part (3) and the resistor element (4) each have a substantially round cross-section, in particular a substantially circular cross-section, in a sectional plane at right angles to the direction of current flow,
**characterized in**
g) that the printed circuit board (18) is a flexible printed circuit board (18) which is curved or bent in the circumferential direction in accordance with the outer contour of the current measuring resistor (1).

12. Manufacturing method according to claim 11, **characterized in that** the joining of the round resistor element (4) to the two connection parts (2, 3) is effected by one of the following joining methods:
a) soldering, in particular hard soldering, in particular vacuum hard soldering,
b) welding, in particular electron beam welding,

13. Manufacturing method according to claim 12, **characterized by** the following step before joining the round resistor element (4) to the two connection parts (2, 3):
Surface finishing of the joining surface, in particular by a coating (5, 6) with nickel, nickel-phosphorus, gold and/or silver as ingredients.

14. Manufacturing process according to one of claims 11 to 13, **characterized by** the following steps after joining the resistor element (4) to the two connection parts (2, 3):
a) shaping the outer contour of the current measuring resistor (1), in particular by turning or milling,
a1) in particular with a larger outer diameter (d2) for the central round resistor element (4) than for the outer connection parts (2, 3),
a2) in particular with a transition contour (7, 8) between the two outer connection parts (2, 3) with the smaller outer diameter (d1) and the central round resistor element (4) with the larger outer diameter (d2), and/or
b) forming at least one flat flattening (17) in the lateral surface of the current measuring resistor (1) for plane-parallel mounting of a printed circuit board (18) on the flattening (17), wherein preferably
b1) numerous flattenings (17) distributed over the circumference of the current measuring resistor (1) are formed in the outer surface of the current measuring resistor (1), and
b2) the printed circuit board (18) is bent several times in accordance with the number of flattenings (17) and has several flat printed circuit board sections, and
b3) the individual flat printed circuit board sections are each mounted plane-parallel on one of the flattenings (17) of the current measuring resistor (1).

15. Manufacturing method according to one of claims 11 to 14, **characterized by** the following steps:
a) mounting a printed circuit board (18) for measuring the voltage drop across the round resistor element (4) on the outer surface of the resistor element (4), in particular by a welded joint, and/or
b) mounting a housing (27, 28) on the current measuring resistor (1), the housing enclosing the round resistor element (4), and
c) inserting at least one measuring card (25, 26) into the housing (27, 28), the measuring card (25, 26) measuring the voltage drop (U_{MESS}) across the round resistor element (4), and/or
d) mounting of at least one coil (23, 24) for energy harvesting from the magnetic field of the current measuring resistor (1) by energy harvesting, and/or
e) mounting of a housing cover on the current measuring resistor (1).

## Revendications

1. Résistance de mesure du courant (1) pour mesurer un courant électrique (I_{AC}), en particulier dans la plage kA dans un réseau à haute tension, avec
a) une première partie de connexion (2) composée d'un matériau conducteur pour introduire le courant électrique (I_{AC}) dans la résistance de mesure du courant (1),
b) une seconde partie de connexion (3) composée d'un matériau conducteur pour évacuer le courant électrique (I_{AC}) hors de la résistance de mesure du courant (1), et
c) un élément de résistance (4) composé d'un matériau de résistance à basse impédance, dans lequel l'élément de résistance (4) est disposé dans la direction du flux de courant entre la première partie de connexion (2) et la seconde partie de connexion (3) et est assemblé aux deux parties de connexion (2, 3) de sorte que le courant électrique (I_{AC}) à mesurer circule lors du fonctionnement à travers l'élément de résistance (4) et génère une chute de tension (U_{MES}) sur l'élément de résistance (4),
d) une carte de circuits imprimés (18), qui est fixée sur la surface extérieure de la résistance de mesure de courant (1) pour mesurer la chute de tension (U_{MES}) sur l'élément de résistance (4),
e) dans laquelle la première partie de connexion (2), la seconde partie de connexion (3) et l'élément de résistance (4) ont une section transversale sensiblement ronde respectivement dans un plan sécant à angle droit par rapport à la direction de flux de courant du courant électrique (I_{AC}), en particulier une section transversale sensiblement ronde circulaire,
**caractérisée en ce**
f) que la carte de circuits imprimés (18) est une carte de circuits imprimés (18) flexible, qui est bombée ou pliée dans la direction périphérique conformément au contour extérieur de la résistance de mesure de courant (1) .

2. Résistance de mesure de courant (1) selon la revendication 1, **caractérisée en ce**
a) **que** l'élément de résistance (4) rond présente un diamètre extérieur (d2), qui est plus grand que le diamètre extérieur (d1) des deux parties de connexion (2, 3) rondes, et/ou
b) **que** l'élément de résistance (4) rond est disposé, par rapport à la direction de flux de courant, au centre entre les deux parties de connexion (2, 3), et/ou
c) **que** la résistance de mesure de courant (1) présente un contour de transition (7, 8) entre les deux parties de connexion (2, 3) extérieures avec le diamètre extérieur (d1) plus petit et l'élément de résistance (4) rond central avec le diamètre extérieur (d2) plus grand,
d) **que** le contour de transition (7, 8) est de préférence lisse et sans pliure pour atteindre une répartition de courant homogène,
e) **que** le contour de transition (7, 8) se trouve de préférence exclusivement dans les parties de raccordement (2, 3), et/ou
f) **que** le contour de transition (7, 8) est au moins en partie concave.

3. Résistance de mesure de courant (1) selon l'une quelconque des revendications précédentes, **caractérisée en ce que** l'élément de résistance (4) rond est assemblé à la première partie de connexion (2) et à la seconde partie de connexion (3) par un des types de liaison suivants :
a) liaison par brasage, en particulier liaison par brasage fort, en particulier liaison par brasage fort sous vide,
b) liaison par soudage, en particulier liaison par soudage par faisceau d'électrons.

4. Résistance de mesure de courant (1) selon l'une quelconque des revendications précédentes, **caractérisée en ce que** l'élément de résistance (4) rond présente, sur les points de jonction avec les deux parties de connexion (2, 3), une amélioration de surface (5, 6) en forme de couche, en particulier avec du nickel, du nickel-phosphore, de l'or ou de l'argent en tant que composants.

5. Résistance de mesure de courant (1) selon l'une quelconque des revendications précédentes,
**caractérisée en ce**
a) **que** la carte de circuits imprimés (18) est disposée dans la direction axiale dans la zone de l'élément de résistance (4) rond et s'étend dans la direction axiale de part et d'autre jusqu'à la surface extérieure des deux parties de connexion (2, 3), et/ou
b) **que** la carte de circuits imprimés (18) est reliée à la résistance de mesure de courant (1) par une liaison par brasage ou par une liaison par soudage, en particulier par
d1) une liaison par soudage aux ultrasons ou
d2) une liaison par soudage au laser, et/ou
c) **que** la liaison par soudage de la carte de circuits imprimés (18) se situe dans la zone des parties de connexion (2, 3) et/ou dans la zone de l'élément de résistance (4) rond, et/ou
d) **que** la carte de circuits imprimés (18) présente au moins deux strates de carte de circuits imprimés, et/ou
e) **que** la carte de circuits imprimés (18) supporte également un capteur de température pour mesurer la température du matériau de résistance, en particulier une résistance CTN (à coefficient de température négatif) ou une résistance CTP (à coefficient de température positif).

6. Résistance de mesure de courant (1) selon la revendication 5, **caractérisée en ce**
a) **que** plusieurs paires de prises de tension (19, 20) sont prévues, dans laquelle chaque paire de prises de tension (19, 20) mesure la chute de tension (U_{MES}) sur l'élément de résistance (4) rond et fournit une valeur de mesure de tension correspondante, et
b) **que** les plusieurs paires de prises de tension (19, 20) sont disposées de manière répartie sur la périphérie de la résistance de mesure de courant (1) pour mesurer la chute de tension (U_{MES}) sur l'élément de résistance (4) rond sur plusieurs points différents de manière répartie sur la périphérie de la résistance de mesure de courant (1),
c) **que** le nombre des plusieurs paires de prises de tension (19, 20) est supérieur à 2, 4, 8, 12, 14, en particulier avec précisément 16 paires de prises de tension (19, 20), et/ou
d) **que** les prises de tension sont installées directement sur la carte de circuits imprimés (18) et reposent directement sur la surface extérieure des parties de connexion (2, 3), et/ou
e) **que** les paires de prises de tension (19, 20) sont reliées respectivement à des résistances de pondération pour pondérer les diverses valeurs de mesure de tension conformément à la valeur de résistance des résistances de pondération, et
f) **que** les résistances de pondération sont disposées sur la carte de circuits imprimés (18).

7. Résistance de mesure de courant (1) selon la revendication 6,
**caractérisée en ce**
a) **que** les plusieurs paires de prises de tension (19, 20) sont reliées à un circuit de mesure, qui détermine à partir des valeurs de mesure la chute de tension (U_{MES}) sur l'élément de résistance (4), et
b) **que** le circuit de mesure calcule la chute de tension (U_{MES}) sur l'élément de résistance (4) à partir des valeurs de mesure de tension pondérées, et/ou
c) **que** le circuit de mesure n'est pas disposé sur la carte de circuits imprimés (18), mais sur une carte de mesure (25, 26) séparée, qui peut être reliée à la carte de circuits imprimés (18) par une ligne, et/ou
d) **que** le circuit de mesure est relié à une interface de données pour transmettre des valeurs de mesure de la chute de tension (U_{MES}) à une unité d'évaluation externe,
e) **que** l'interface de données est de préférence une interface de données électro-optique, laquelle transmet à l'unité d'évaluation externe les valeurs de mesure par l'intermédiaire d'une fibre optique, et/ou
f) **que** sont prévues pour créer de la redondance lors de la mesure deux cartes de mesure (25, 26), qui présentent respectivement un circuit de mesure, et/ou
g) **que** le circuit de mesure présente au moins deux ou au moins trois chemins de mesure, dans laquelle
les divers chemins de mesure reçoivent de la carte de circuits imprimés (18) respectivement les valeurs de mesure pour la chute de tension sur de l'élément de résistance (4) rond, et/ou
h) que le premier chemin de mesure et le deuxième chemin de mesure présentent la même amplification de signal, tandis que le troisième chemin de mesure présente une amplification de signal inférieure.

8. Résistance de mesure de courant (1) selon l'une quelconque des revendications 5 à 7,
**caractérisée en ce**
a) **que** le contour extérieur sensiblement rond de la résistance de mesure de courant (1) présente au moins une zone aplatie (17) plane dans la surface extérieure de la résistance de mesure de courant (1) pour monter la carte de circuits imprimés (18) de manière parallèle et plane sur la zone aplatie (17), et/ou
b) **que** plusieurs zones aplaties (17) sont disposées de manière répartie sur la périphérie de la résistance de mesure de courant (1) dans la surface extérieure de la résistance de mesure de courant (1), en particulier au moins 2, 4, 6, 8, 10, 12, ou 14, de préférence précisément 16, et
c) **que** les zones aplaties (17) se trouvent dans la surface extérieure de l'élément de résistance (4) rond,
et/ou
d) que les zones aplaties (17) s'étendent dans la direction de flux de courant de part et d'autre jusque dans les parties de connexion (2, 3), et/ou
e) que la carte de circuits imprimés (18) est pliée à maintes reprises conformément au nombre des zones aplaties (17) et présente plusieurs sections planes de carte de circuits imprimés, qui sont montées respectivement de manière parallèle et plane sur une des zones aplaties (17).

9. Résistance de mesure de courant (1) selon l'une quelconque des revendications précédentes,
**caractérisée en ce**
a) **qu'**au moins une bobine (23, 24) est prévue pour récupérer de l'énergie du champ magnétique de la résistance de mesure de courant (1) par récupération d'énergie, et
b) **que** la bobine (23, 24) fournit l'énergie électrique nécessaire au fonctionnement du circuit de mesure, en particulier seule ou avec une alimentation en énergie supplémentaire, et/ou
c) **que** la bobine (23, 24) présente au moins 20, 50, 100, 140 spires, en particulier précisément 150 spires, et/ou
d) **que** la bobine (23, 24) contient un noyau magnétique, et/ou
e) **que** sont prévues, pour récupérer de l'énergie, plusieurs bobines (23, 24), qui entourent de manière annulaire respectivement une des deux parties de connexion (2, 3), et/ou
f) **qu'**un accumulateur de courant est intégré dans la résistance de mesure de courant (1), en particulier au moins un plafond de puissance avec une capacité d'au moins 10 mF, 50 mF, 100 mF, 500 mF ou d'au moins 1000 mF, et/ou
g) **qu'**une cellule photoélectrique est intégrée dans la résistance de mesure de courant (1) pour la seule alimentation en courant ou pour l'alimentation en courant de soutien.

10. Résistance de mesure de courant (1) selon l'une quelconque des revendications précédentes,
**caractérisée en ce**
a) **que** le matériau conducteur est du cuivre ou un alliage de cuivre, et/ou
b) **que** le matériau conducteur des parties de connexion (2, 3) a une résistance électrique spécifique inférieure à celle du matériau de résistance de l'élément de résistance (4) rond, et/ou
c) **que** le matériau de résistance de l'élément de résistance (4) rond est un alliage de cuivre-manganèsenickel, en particulier
c1) avec 25 % en poids de manganèse, 10 % en poids de nickel et le reste de cuivre, ou
c2) avec 12 % en poids de manganèse, 2 % en poids de nickel et le reste de cuivre, et/ou
d) **que** le matériau de résistance de l'élément de résistance (4) rond présente une résistance électrique spécifique inférieure à 1000 µΩcm, 500 µΩcm, 250 µΩcm, 100 µΩcm ou 50 µΩcm, et/ou
e) **que** le matériau conducteur présente une résistance électrique spécifique inférieure à 20 µΩcm, 10 µΩcm, 5 µΩcm ou 2 µΩcm, et/ou
f) **que** l'élément de résistance (4) rond, la première partie de connexion et/ou la seconde partie de connexion sont réalisés de manière massive dans cavités, et/ou
g) **que** les parties de connexion (2, 3) présentent dans leur surface extérieure respectivement une rainure longitudinale (11, 12) s'étendant axialement, qui part de la surface frontale des parties de connexion (2, 3), et/ou
h) **que** les deux parties de connexion (2, 3) présentent dans leur surface extérieure respectivement au moins un alésage borgne (13-16) s'étendant radialement pour le montage de carter, en particulier dans le contour de transition (7, 8), et/ou
i) **que** les deux parties de connexion (2, 3) présentent dans leur surface frontale respectivement un alésage borgne (9, 10) s'étendant axialement, en particulier avec un filetage intérieur, en particulier de manière centrée et coaxiale, et/ou
j) **que** les deux parties de connexion (2, 3) présentent dans leur surface extérieure respectivement une rainure annulaire (21, 22) périphérique avec une section transversale polygonale, qui fait office d'aide à la fabrication et/ou
k) **que** le diamètre extérieur (d2) de l'élément de résistance (4) rond est d'au moins 6 cm, de 7 cm, 8 cm ou 9 cm, en particulier sensiblement de 10 cm, et/ou
l) que le diamètre extérieur (d1) des parties de connexion (2, 3) rondes est d'au moins 2 cm, 3 cm, 4 cm ou 5 cm, et/ou
m) **que** la résistance de mesure de courant (1) présente dans la direction de flux de courant une longueur axiale d'au moins 10 cm, 20 cm, 30 cm, 40 cm, 50 cm ou 60 cm, en particulier sensiblement de 64 cm, et/ou
n) **que** l'élément de résistance (4) rond présente dans la direction de flux de courant une longueur axiale d'au moins 1 cm, 2 cm, 3 cm, 4 cm, 5 cm ou 6 cm, en particulier sensiblement de 7 cm, et/ou
o) **que** les deux parties de connexion (2, 3) présentent dans la direction de flux de courant respectivement une longueur axiale d'au moins 10 cm, 20 cm, 25 cm ou 30 cm, en particulier sensiblement de 31 cm, et/ou
p) **que** les deux parties de connexion (2, 3) ont respectivement une masse d'au moins 1 kg, 2 kg, 5 kg, 10 kg, 15 kg ou de 20 kg, en particulier sensiblement de 22 kg, et/ou
q) **que** l'élément de résistance (4) rond présente une masse d'au moins 0,5 kg, 1 kg, 1,5 kg ou 2 kg, en particulier sensiblement de 2,5 kg, et/ou
r) **que** la résistance de mesure de courant (1) présente en cas de courant alternatif un courant de charge permanent d'au moins 1 kA, 5 kA, 10 kA, 25 kA, 50 kA, 75 kA, 95 kA ou d'au moins 100 kA, et/ou
s) **que** la résistance de mesure de courant (1) est adaptée dans le cas d'un courant alternatif pour un niveau de tension d'au moins 1 kV, 5 kV, 10 kV, 50 kV, 110 kV, 220 kV ou d'au moins 380 kV, et/ou
t) **que** la première partie de connexion, la seconde partie de connexion et/ou l'élément de résistance (4) rond ont une section transversale polygonale respectivement dans un plan sécant à angle droit par rapport à la direction de flux de courant du courant électrique (I_{AC}) avec au moins 12, 14 ou 16 angles pour former la section transversale sensiblement ronde.

11. Procédé de fabrication pour une résistance de mesure de courant (1), en particulier pour une résistance de mesure de courant (1) pour la mesure de courant dans la plage de kA dans un réseau à haute tension, en particulier pour une résistance de mesure de courant (1) selon l'une quelconque des revendications précédentes, avec les étapes suivantes :
a) de fourniture d'une première partie de connexion (2) composée d'un matériau conducteur pour introduire le courant électrique (I_{AC}) dans la résistance de mesure de courant (1),
b) de fourniture d'une seconde partie de connexion (3) composée d'un matériau conducteur pour évacuer le courant électrique (I_{AC}) hors de la résistance de mesure de courant (1),
c) de fourniture d'un élément de résistance (4) composé d'un matériau de résistance à faible impédance,
d) d'assemblage de l'élément de résistance (4) aux deux parties de connexion (2, 3) en la résistance de mesure de courant (1) de sorte que l'élément de résistance (4) est disposé dans la direction de flux de courant entre la première partie de connexion (2) et la seconde partie de connexion (3) et le courant électrique (I_{AC}) à mesurer circule lors du fonctionnement à travers l'élément de résistance (4) et génère une chute de tension (U_{MES}) sur l'élément de résistance (4),
e) de fixation d'une carte de circuits imprimés (18) sur la surface extérieure de la résistance de mesure de courant (1) pour mesurer la chute de tension (U_{MES}) sur l'élément de résistance (4),
f) dans lequel la première partie de connexion (2), la seconde partie de connexion (3) et l'élément de résistance (4) ont une section transversale sensiblement ronde respectivement dans un plan sécant à angle droit par rapport à la direction de flux de courant, en particulier une section transversale sensiblement ronde circulaire,
**caractérisé en ce**
g) que la carte de circuits imprimés (18) est une carte de circuits imprimés (18) flexible, qui est bombée ou pliée dans la direction périphérique conformément au contour extérieur de la résistance de mesure de courant (1) .

12. Procédé de fabrication selon la revendication 11, **caractérisé en ce que** l'assemblage de l'élément de résistance (4) rond aux deux parties de connexion (2, 3) est effectué par un des procédés de jonction suivants :
a) brasage, en particulier brasage fort, en particulier brasage fort sous vide,
b) soudage, en particulier soudage par faisceau d'électrons.

13. Procédé de fabrication selon la revendication 12, **caractérisé par** l'étape suivante avant l'assemblage de l'élément de résistance (4) rond aux deux parties de connexion (2, 3) :
amélioration de la surface de la surface de fonction, en particulier par un revêtement (5, 6) avec du nickel, du nickel-phosphore, de l'or et/ou de l'argent en tant que composants.

14. Procédé de fabrication selon l'une quelconque des revendications 11 à 13, **caractérisé par** des étapes suivantes après l'assemblage de l'élément de résistance (4) aux deux parties de connexion (2, 3) :
a) de façonnage du contour extérieur de la résistance de mesure de courant (1), en particulier par rotation ou par fraisage,
a1) en particulier avec un diamètre extérieur (d2) plus grand pour l'élément de résistance (4) rond central que pour les parties de connexion (2, 3) extérieures,
a2) en particulier avec un contour de transition (7, 8) entre les deux parties de connexion (2, 3) extérieures avec le diamètre extérieur (d1) plus petit et l'élément de résistance (4) rond central avec le diamètre extérieur (d2) plus grand, et/ou
b) de façonnage d'au moins une zone aplatie (17) plane dans la surface extérieure de la résistance de mesure de courant (1) pour le montage plan parallèle d'une carte de circuits imprimés (18) sur la zone aplatie (17), dans lequel de préférence
b1) de nombreuses zones aplaties (17) sont façonnées dans la surface extérieure de la résistance de mesure de courant (1) de manière répartie sur la périphérie de la résistance de mesure de courant (1), et
b2) la carte de circuits imprimés (18) est pliée à maintes reprises conformément au nombre des zones aplaties (17) et présente plusieurs sections de carte de circuits imprimés planes, et
b3) les diverses sections de carte de circuits imprimés planes sont montées respectivement de manière plane parallèle sur une des zones aplaties (17) de la résistance de mesure de courant (1).

15. Procédé de fabrication selon l'une quelconque des revendications 11 à 14, **caractérisé par** l'étape suivante :
a) de fixation d'une carte de circuits imprimés (18) pour mesurer la chute de tension sur l'élément de résistance (4) rond sur la surface extérieure de l'élément de résistance (4), en particulier par une liaison par soudage, et/ou
b) de montage d'un carter (27, 28) sur la résistance de mesure de courant (1), dans lequel le carter renferme l'élément de résistance (4) rond, et
c) d'introduction d'au moins une carte de mesure (25, 26) dans le carter (27, 28), dans lequel la carte de mesure (25, 26) mesure la chute de tension (U_{MES}) sur l'élément de résistance (4) rond, et/ou
d) de montage d'au moins une bobine (23, 24) pour récupérer de l'énergie du champ magnétique de la résistance de mesure de courant (1) par récupération d'énergie et/ou
e) de montage d'un couvercle de carter sur la résistance de mesure de courant (1).
